# FASCICULE DE BREVET EUROPEEN

(11) **EP 2 961 711 B1**
(45) Date de publication et mention de la délivrance du brevet: **18.08.2021**
(21) Numéro de dépôt: 14713175.9
(22) Date de dépôt: 25.02.2014
(51) Int. Cl.: C03C 17/34, C08J 7/00

(54) **SUBSTRAT REVÊTU D'UN EMPILEMENT BAS-EMISSIF**
BESCHICHTETES SUBSTRAT MIT EINER NIEDRIGEN EMISSIVITÄT
SUBSTRATE COATED WITH A LOW-EMISSIVITY COATING

(30) Priorité: 27.02.2013 FR 1351729
(43) Date de publication de la demande: 06.01.2016
(73) Titulaire: SAINT-GOBAIN GLASS FRANCE, 92400 Courbevoie (FR)
(72) Inventeur: STERNCHUSS, Juliette, F-78100 Saint Germain en Laye (FR); HAGEN, Jan, 53123 Bonn (DE)
(74) Mandataire: Saint-Gobain Recherche
(86) Numéro de dépôt international: PCT/FR2014/050392
(87) Numéro de publication internationale: WO 2014/131980

(56) Documents cités:
- WO-A1-2011/122152
- FR-A1- 2 963 343
- JP-A- 11- 149 063
- US-A- 4 504 109
- US-A1- 2012 048 722
- US-A1- 2012 164 420
- US-B1- 6 797 388
- None

## Description

L'invention se rapporte au domaine des matériaux comprenant un substrat revêtu sur au moins une de ses faces d'un empilement de couches minces conférant des propriétés de faible émissivité.

Les revêtements bas-émissifs déposés sur des substrats, notamment en verre, ont des propriétés de réflexion de l'infrarouge, et donc de la chaleur, utiles dans un grand nombre d'applications.

Dans les vitrages équipant les véhicules terrestres, notamment automobiles, ferroviaires, ou encore les véhicules aériens ou maritimes, les vitrages bas-émissifs permettent par temps chaud de réfléchir vers l'extérieur une partie du rayonnement solaire, et donc de limiter l'échauffement de l'habitacle desdits véhicules, et le cas échéant de réduire les dépenses de climatisation. A l'inverse, par temps froid, ces vitrages permettent de conserver la chaleur au sein de l'habitacle, et par conséquent de réduire l'effort énergétique de chauffage. Il en est de même dans le cas des vitrages équipant les bâtiments.

Les propriétés de faible émissivité sont également utiles pour conférer aux vitrages des propriétés anti-condensation. Les vitrages à très faible coefficient de transmission thermique sont en effet sujets à l'apparition de condensation d'eau sur leur surface extérieure, sous la forme de buée ou de givre. En cas de ciel dégagé durant la nuit, les échanges de chaleur par rayonnement avec le ciel entraînent une baisse de température qui n'est plus suffisamment compensée par les apports de chaleur provenant de l'intérieur de l'habitation. Lorsque la température de la surface extérieure du vitrage passe en dessous du point de rosée, l'eau condense sur ladite surface, gênant la visibilité au travers du vitrage le matin, parfois pendant plusieurs heures.

Des revêtements bas-émissifs peuvent également être déposés sur des substrats de verre utilisés dans des vitrages anti-feu, des portes de four, ou à l'inverse des portes ou enceintes de réfrigérateurs ou de congélateurs, afin de limiter les transferts de chaleur au travers du vitrage ou de la porte. Il s'agit dans un cas de sécuriser les personnes en limitant l'élévation de température du côté du vitrage ou de la porte opposé à la source de chaleur, dans l'autre cas de réduire les dépenses énergétiques.

Dans ces différentes applications, il est connu d'utiliser des empilements de couches minces contenant une couche d'un oxyde transparent électro-conducteur, fréquemment appelé TCO (pour « transparent conductive oxide »). Ces couches conductrices et néanmoins transparentes présentent en effet de faibles émissivités, corrélées avec des faibles résistivités ou résistances carrées.

Les documents JP 11-149063 A et US 6,797,388 A1 décrit des matériaux comprenant un substrat revêtu par deux couches des transparent électro-conducteurs séparées par au moins une couche intermédiaire diélectrique.

L'invention vise à améliorer ce type d'empilements, en particulier leur résistance à la flexion et/ou au bombage. D'autres avantages de l'invention apparaîtront dans la suite du texte.

A cet effet, l'invention a pour objet un matériau comprenant un substrat revêtu sur au moins une partie d'au moins une de ses faces d'un empilement de couches minces comprenant au moins deux couches à base d'un oxyde transparent électro-conducteur séparées par au moins une couche intermédiaire diélectrique dont l'épaisseur physique est d'au plus 50 nm, notamment 30 ou même 20 nm, aucune couche métallique n'étant disposée entre lesdites couches à base d'un oxyde transparent électro-conducteur, ledit empilement comprenant en outre au moins une couche barrière à l'oxygène au-dessus de la couche à base d'un oxyde transparent électro-conducteur la plus éloignée du substrat, chaque couche à base d'un oxyde transparent électro-conducteur possédant une épaisseur physique comprise dans un domaine allant de 20 à 80 nm.

De préférence, le substrat est revêtu sur une seule de ses faces d'un tel empilement.

Par les expressions « en-dessous » ou « sous » qualifiant la position relative d'une première couche par rapport à une deuxième dans l'empilement, on entend que la première couche est plus proche du substrat que la deuxième couche. Par les expressions « au-dessus » ou « sur » qualifiant la position relative d'une première couche par rapport à une deuxième dans l'empilement, on entend que la première couche est plus éloignée du substrat que la deuxième couche. Ces expressions ne signifient pas nécessairement que les deux couches sont en contact, ce qui n'est toutefois pas exclu, et qui est même parfois préféré, comme on le verra dans la suite du texte.

Par l'expression « à base de », on entend notamment que la couche comprend au moins 80%, voire 90% et même 95% en poids du composé considéré. La couche peut même être avantageusement constituée ou essentiellement constituée d'un tel composé.

L'empilement comprend au moins deux couches minces à base d'un oxyde transparent électro-conducteur (TCO). Le nombre de couches à base de TCO est de préférence compris dans un domaine allant de 2 à 5, notamment de 2 à 4. De préférence, ce nombre est de 2 ou 3, avantageusement 2.

Par l'expression « à base de », on entend notamment que chaque couche à base de TCO comprend au moins 80%, voire 90% et même 95% en poids d'un tel oxyde. Chaque couche à base de TCO est même avantageusement constituée d'un tel oxyde.

Avantageusement, chaque couche de TCO de l'empilement est à base ou constituée du même TCO, ce qui permet de simplifier les conditions de dépôt. Alternativement, les couches de TCO peuvent être de nature différente. Ainsi, l'empilement comprend de préférence exactement deux couches d'un même TCO.

De préférence, chaque oxyde transparent électro-conducteur est choisi parmi l'oxyde mixte d'étain et d'indium (ITO), l'oxyde mixte d'indium et de zinc (IZO), l'oxyde de zinc dopé au gallium ou à l'aluminium (AZO), l'oxyde de titane dopé au niobium, le stannate de cadmium ou de zinc, l'oxyde d'étain dopé au fluor et/ou à l'antimoine.

Dans le cas de l'oxyde de zinc dopé à l'aluminium, le taux de dopage (c'est-à-dire le poids d'oxyde d'aluminium rapporté au poids total) est de préférence inférieur à 3%. Dans le cas du gallium, le taux de dopage peut être plus élevé, typiquement compris dans un domaine allant de 5 à 6%. Pour les couches à base d'oxyde d'étain dopé au fluor, le pourcentage atomique de fluor est de préférence d'au plus 5%, généralement de 1 à 2%.

L'indice de réfraction de la couche à base de TCO pour une longueur d'onde de 550 nm est de préférence compris dans un domaine allant de 1,7 à 2,5.

Selon un mode préféré, chaque couche à base de TCO est une couche à base d'ITO, et même une couche d'ITO. Selon un mode particulièrement préféré, l'empilement comprend exactement deux couches d'ITO. Le pourcentage atomique de Sn est avantageusement compris dans un domaine allant de 5 à 70%, notamment de 10 à 60%. L'ITO présente une bonne durabilité climatique, une excellente résistance à la corrosion, et est également particulièrement apprécié pour sa conductivité électrique élevée, autorisant l'emploi de faibles épaisseurs pour obtenir un même niveau d'émissivité, ce qui permet de minimiser la perte de facteur solaire. Aisément déposées par un procédé de pulvérisation cathodique, notamment assisté par champ magnétique, appelé « procédé magnétron », ces couches se caractérisent par une plus faible rugosité, et donc un plus faible encrassement. Lors de la fabrication, de la manutention et de l'entretien des vitrages, les couches plus rugueuses ont en effet tendance à piéger divers résidus, qui sont particulièrement difficiles à éliminer.

Chaque couche à base d'un oxyde transparent électro-conducteur possède une épaisseur physique comprise dans un domaine allant de 20 à 80 nm, notamment de 30 à 80 nm. L'épaisseur physique cumulée de toutes les couches à base d'un oxyde transparent électro-conducteur est de préférence comprise dans un domaine allant de 40 à 400 nm, notamment de 60 à 300 nm. Lorsqu'il s'agit de couches à base d'ITO ou constituées d'ITO, et notamment lorsque l'empilement comprend exactement deux de ces couches, l'épaisseur physique cumulée de toutes les couches à base d'ITO ou constituées d'ITO est de préférence comprise dans un domaine allant de 40 à 200 nm, notamment de 60 à 160 nm.

L'épaisseur physique de chaque couche de TCO peut être identique ou différente.

Il est apparu aux inventeurs que l'émissivité de l'empilement pouvait être directement réglée par le choix de l'épaisseur physique cumulée de toutes les couches de TCO. De manière surprenante, malgré la présence d'au moins une couche intermédiaire, l'émissivité de l'empilement de n (notamment 2) couches de TCO équivaut à celle d'un empilement comprenant une seule couche du même TCO, mais dont l'épaisseur serait égale à l'épaisseur cumulée des n couches. Il est donc par exemple possible d'obtenir la même émissivité (ou résistance carrée) en remplaçant une couche unique de TCO (notamment d'ITO) de 100 nm d'épaisseur physique par deux couches du même TCO ayant chacune 50 nm d'épaisseur physique, séparées par au moins une couche intermédiaire. En revanche, les propriétés de résistance à la flexion et/ou au bombage se trouvent nettement améliorées par un tel choix, comme démontré dans la suite du texte. En outre, ce choix confère une certaine souplesse dans la conception et la fabrication industrielle de l'empilement, chacune des couches de TCO pouvant être ajustée indépendamment l'une de l'autre. Par exemple, la première couche de TCO la plus proche du substrat peut être déposée de manière à être plus oxydée et donc plus conductrice que la seconde, cette dernière étant en revanche plus durable, car moins protégée.

L'épaisseur physique cumulée des couches de TCO est donc choisie en fonction de l'émissivité voulue ou imposée par l'application. Par « émissivité », on entend l'émissivité normale à 283 K au sens de la norme EN 12898. L'émissivité de l'empilement est de préférence d'au plus 0,4 ou 0,3, notamment 0,25 et même 0,2.

Dans le cas de vitrages automobiles (pare-brise, toits, latérales, lunette arrière), l'émissivité visée est de préférence d'au plus 0,25, notamment 0,2 et même 0,15 ou 0,1.

Dans le cas de vitrages anti-condensation, pour une performance anti-condensation donnée, l'émissivité recherchée dépend de différents facteurs, dont l'inclinaison du vitrage et son coefficient de transmission thermique Ug. Typiquement, un vitrage incliné et/ou à faible coefficient de transmission thermique nécessitera une émissivité plus faible, et par conséquent une épaisseur cumulée plus élevée. Lorsque le vitrage est destiné à être placé en position verticale, l'émissivité est de préférence d'au plus 0,4, voire 0,3. L'épaisseur physique cumulée sera alors généralement d'au moins 60 nm, souvent d'au plus 120 nm. Lorsque le vitrage est destiné à être placé en position inclinée, par exemple dans des applications en toiture, ou lorsque le coefficient de transmission thermique Ug est inférieur ou égal à 1 W/(m².K), voire 0,6 W/(m².K), l'émissivité est de préférence d'au plus 0,3, voire 0,2 et même 0,18. L'épaisseur physique cumulée sera de préférence d'au moins 60 nm, voire 70 ou 100 nm et d'au plus 200 nm.

Selon l'invention, l'empilement comprend au moins deux couches à base d'un oxyde transparent électro-conducteur séparées par au moins une couche intermédiaire diélectrique.

La présence de métaux entre les couches de TCO est exclue car elle confère à l'empilement de mauvaises propriétés de résistance à la corrosion ainsi qu'une faible résistance au bombage ou à la trempe et diminue la transmission lumineuse. Ainsi, l'empilement dans son ensemble ne comprend normalement pas de couches métalliques.

Par l'emploi du terme « séparées », on entend que la couche intermédiaire est disposée entre deux couches de TCO, la couche intermédiaire n'étant pas nécessairement en contact avec une des couches de TCO.

Le nombre de couches intermédiaires séparant les couches à base de TCO varie de préférence de 1 à 5, notamment de 1 à 3 ou de 1 ou 2. Avantageusement, l'empilement de couches minces comprend au moins deux couches (notamment deux couches) à base d'un oxyde transparent électro-conducteur séparées par au plus deux couches intermédiaires, notamment par une seule couche intermédiaire.

De préférence, les couches à base de TCO sont séparées deux à deux par une seule couche intermédiaire, en contact avec les deux couches à base de TCO qui l'encadrent. Lorsque l'empilement comprend exactement deux couches à base de TCO, l'empilement comprend alors une séquence du type TCO / couche intermédiaire / TCO, notamment ITO / couche intermédiaire / ITO.

La ou chaque couche intermédiaire diélectrique est de préférence à base d'un composé choisi parmi les oxydes, les nitrures ou les oxynitrures de silicium, d'aluminium, de titane, d'étain, de zinc, de zirconium, de niobium, de nickel, de chrome ou d'un de leurs mélanges. Elle est de préférence essentiellement constituée d'un tel composé, voire constituée d'un tel composé.

Plus particulièrement, la ou chaque couche intermédiaire diélectrique est de préférence essentiellement constituée d'un composé choisi parmi un oxyde, nitrure ou oxynitrure de silicium et/ou d'aluminium, un nitrure ou un oxyde de titane, un oxyde de nickel et de chrome, un nitrure de niobium, un oxyde d'étain et de zinc. De manière préférée, la ou chaque couche intermédiaire diélectrique est à base (ou essentiellement constituée) d'oxyde de silicium, de nitrure de silicium, d'oxyde de titane, d'oxyde d'étain et de zinc. L'oxyde ou le nitrure de silicium sont particulièrement préférés. Le nitrure de silicium ou l'oxyde d'étain et de zinc sont particulièrement appréciés car leur indice de réfraction est proche de celui de l'ITO, si bien que leur présence ne perturbe pas les propriétés optiques de l'empilement. De préférence, l'indice de réfraction pour une longueur d'onde de 550 nm de la ou chaque couche intermédiaire (notamment de l'unique couche intermédiaire) est d'au moins 1,8, notamment 1,9, avantageusement compris dans un domaine allant de 1,8 à 2,5, notamment de 1,9 à 2,2.

Ces appellations ne préjugent pas de la stœchiométrie réelle des couches et/ou de la présence de dopants. A titre d'exemples, l'oxyde de silicium n'est pas nécessairement de formule exacte SiO₂ et/ou peut être dopé, par exemple par des atomes d'aluminium ou de bore, dans le but de faciliter son dépôt par des procédés de pulvérisation cathodique. De même, le nitrure de silicium ne possède pas nécessairement une stœchiométrie répondant à la formule Si₃N₄, et/ou peut être dopé, par exemple par des atomes d'aluminium, de zirconium ou de bore, dans le but de faciliter son dépôt par des procédés de pulvérisation cathodique. L'expression « essentiellement constitué » inclut la possibilité d'un tel dopage.

L'épaisseur physique de la (ou chaque) couche intermédiaire diélectrique est de préférence comprise dans un domaine allant de 2 à 30 nm, ou de 2 à 20 nm, notamment de 5 à 15 nm, et même de 8 à 12 nm. La présence de fines couches intermédiaires permet de manière surprenante d'améliorer la résistance à la flexion et au bombage des empilements, sans toutefois perturber leur aspect optique.

Les différents modes préférés décrits ci-avant peuvent bien entendu être combinés les uns avec les autres, selon toutes combinaisons possibles. Selon une combinaison particulièrement préférée, l'empilement comprend exactement deux couches d'ITO encadrant une seule couche intermédiaire diélectrique et en contact direct avec elle. L'empilement comprend donc une séquence du type ITO / couche intermédiaire / ITO, notamment ITO / SiNₓ / ITO ou ITO / SiOₓ / ITO, ou ITO / SnZnOₓ / ITO, ou ITO / TiOₓ / ITO, les appellations SiNₓ, SiOₓ, SnZnOₓ ou TiOₓ ne préjugeant pas de la présence de dopants, comme expliqué *supra.*

L'empilement comprend, au-dessus de la couche à base de TCO la plus éloignée du substrat, (au moins) une couche barrière à l'oxygène.

La couche barrière à l'oxygène a pour but de protéger contre l'oxydation les couches à base de TCO, notamment les couches d'ITO. Plus particulièrement, la couche barrière, disposée sur la couche à base de TCO la plus éloignée du substrat, et de préférence en contact avec elle, permet de contrôler très précisément l'état d'oxydation de cette dernière, et donc ses propriétés électriques et optiques après traitements thermiques, notamment de trempe ou de bombage.

L'épaisseur physique de la couche barrière à l'oxygène est de préférence comprise dans un domaine allant de 5 à 100 nm, notamment de 10 à 50 nm.

La couche barrière est de préférence à base d'un composé choisi parmi le nitrure de silicium, l'oxyde de niobium, l'oxyde de tungstène, l'oxyde de bismuth, l'oxyde de titane, le nitrure de zirconium et le nitrure d'aluminium. La couche barrière est de préférence essentiellement constituée de nitrure de silicium, qui s'est révélé le plus efficace. Comme indiqué précédemment, cette appellation ne préjuge pas de la stœchiométrie réelle de la couche et/ou de la présence de dopants, notamment d'aluminium, de bore ou de zirconium.

L'empilement comprend de préférence au moins une autre couche, disposée sous la couche à base de TCO la plus proche du substrat et/ou sur la couche barrière à l'oxygène la plus éloignée du substrat. Comme indiqué précédemment, par les termes « sur » ou « sous », on n'entend pas nécessairement que les couches sont en contact, seulement qu'elles sont plus proche du substrat (« sous ») ou plus éloignées (« sur »). Le cas où ces couches sont effectivement en contact direct avec les couches de TCO ou barrière les plus proches n'est toutefois pas exclu, comme on le verra par la suite.

Avantageusement, l'empilement comprend au moins une couche (notamment une, deux ou trois) disposée sous la couche à base de TCO la plus proche du substrat et au moins une couche (notamment, une, deux, ou trois) disposée sur la couche barrière à l'oxygène la plus éloignée du substrat.

L'empilement comprend ainsi avantageusement, sous la couche à base de TCO la plus proche du substrat, (au moins) une couche d'adhésion et/ou au moins une couche ou un empilement de neutralisation.

Disposée entre le substrat et la couche à base de TCO la plus proche de ce dernier, une couche ou un empilement de neutralisation permet d'influer sur l'aspect en réflexion du matériau, notamment sur sa couleur en réflexion. Des couleurs bleutées, caractérisées par des coordonnées colorimétriques b* négatives, sont souvent préférées. Dans le cas d'une couche unique, son indice de réfraction est de préférence compris entre l'indice de réfraction du substrat et l'indice de réfraction de la couche à base de TCO. A titre d'exemples non limitatifs, il est possible d'utiliser une couche d'oxyde mixte de silicium et d'étain (SiSnOₓ), d'oxycarbure ou d'oxynitrure de silicium, d'oxyde d'aluminium, d'oxyde mixte de titane et de silicium. Un empilement de couches comprenant deux couches à haut et bas indice, par exemple un empilement TiOₓ/SiOₓ, SiNₓ/SiOₓ est également utilisable. L'épaisseur physique de cette ou de ces couches est de préférence comprise dans un domaine allant de 5 à 70 nm, notamment de 15 à 30 nm. Les couches ou empilements de neutralisation préférés sont une couche de neutralisation en un oxynitrure de silicium ou un empilement SiNₓ/SiOₓ. De préférence, la couche ou l'empilement de neutralisation est en contact direct avec à la fois le substrat et la couche de TCO la plus proche du substrat.

Disposée entre le substrat et la couche à base de TCO la plus proche de ce dernier, une couche d'adhésion, qui présente avantageusement un indice de réfraction proche de celui du substrat (notamment de verre), permet d'améliorer la tenue à la trempe et au bombage en favorisant l'accrochage de la couche de TCO. La couche d'adhésion est de préférence en silice. Son épaisseur physique est de préférence comprise dans un domaine allant de 20 à 200 nm, notamment de 30 à 150 nm. La couche d'adhésion est de préférence en contact direct avec à la fois le substrat et la couche de TCO la plus proche de ce dernier.

L'empilement comprend avantageusement, sur la couche barrière la plus éloignée du substrat, au moins une couche à bas indice de réfraction.

De préférence, une couche à bas indice de réfraction, typiquement d'un indice d'au plus 1,8, voire 1,50 et même 1,48 (pour une longueur d'onde de 550 nm), notamment à base de silice ou essentiellement constituée de silice, est disposée au-dessus de la couche barrière à l'oxygène. Son but est de régler les propriétés optiques et/ou thermiques du revêtement. Notamment, son épaisseur peut être adaptée afin de réduire le facteur de réflexion de l'empilement ou d'optimiser son facteur solaire. L'épaisseur physique de la couche à bas indice est de préférence comprise dans un domaine allant de 20 à 100 nm, notamment de 30 nm à 90 nm, voire de 40 à 80 nm.

La couche à bas indice peut être la dernière couche de l'empilement, donc celle en contact avec l'atmosphère. Alternativement, au moins une autre couche mince peut être déposée au-dessus de la couche à bas indice de réfraction.

On peut ainsi disposer au-dessus de, de préférence sur et en contact avec, la couche à base d'oxyde de silicium, une couche de protection à base d'oxyde de titane, dont l'épaisseur physique est avantageusement d'au plus 30 nm, notamment 20 nm, voire 10 nm. Cette couche est avantageusement photocatalytique.

De très fines couches photocatalytiques, bien que moins actives photocatalytiquement parlant, présentent toutefois de bonnes propriétés auto-nettoyantes, antisalissures et antibuée. Même pour des couches de très faible épaisseur, l'oxyde de titane photocatalytique présente en effet la particularité, lorsqu'il est irradié par la lumière solaire, de devenir extrêmement hydrophile, avec des angles de contact à l'eau inférieurs à 5° et même 1°, ce qui permet à l'eau de ruisseler plus facilement, en éliminant les salissures déposées à la surface de la couche. En outre, les couches plus épaisses présentent une réflexion lumineuse plus élevée, ce qui a pour effet de diminuer le facteur solaire. La couche de protection, notamment photocatalytique, est de préférence une couche en oxyde de titane, en particulier dont l'indice de réfraction est compris dans un domaine allant de 2,0 à 2,5. L'oxyde de titane est de préférence au moins partiellement cristallisé sous la forme anatase, qui est la phase la plus active du point de vue de la photocatalyse. Des mélanges de phase anatase et rutile se sont aussi révélés très actifs. Le dioxyde de titane peut éventuellement être dopé par un ion métallique, par exemple un ion d'un métal de transition, ou par des atomes d'azote, de carbone, de fluor.... Le dioxyde de titane peut également être sous-stœchiométrique ou sur-stœchiométrique. Dans ce mode de réalisation, l'intégralité de la surface de la couche de protection (éventuellement photocatalytique), notamment à base d'oxyde de titane, est de préférence en contact avec l'extérieur, de manière à pouvoir pleinement mettre en application sa fonction autonettoyante. Il peut toutefois être intéressant de revêtir la couche photocatalytique, notamment en dioxyde de titane, d'une fine couche hydrophile, notamment à base de silice afin d'améliorer dans le temps la persistance de l'hydrophilie.

Alternativement, l'empilement peut ne pas comprendre de couche photocatalytique.

Les différents modes de réalisation préférés décrits ci-avant peuvent bien entendu être combinés entre eux. Toutes les combinaisons possibles ne sont pas explicitement décrites dans le présent texte pour ne pas l'alourdir inutilement.

Parmi les combinaisons préférées, l'empilement comprend (ou est constitué de) successivement à partir du substrat :
- une couche d'adhésion, par exemple à base ou essentiellement constituée de silice,
- une première couche de TCO (notamment ITO),
- une couche intermédiaire diélectrique, par exemple à base ou essentiellement constituée de silice, de nitrure de silicium ou d'oxyde d'étain et de zinc,
- une deuxième couche de TCO (notamment ITO),
- une couche barrière à l'oxygène, par exemple à base ou essentiellement constituée de nitrure de silicium,
- une couche à bas indice de réfraction, par exemple à base ou essentiellement constituée de silice.

Une couche ou un empilement de neutralisation peut remplacer la couche d'adhésion ou être déposée entre la couche d'adhésion et la première couche de TCO. Ainsi, dans une autre combinaison préférée, l'empilement comprend (ou est constitué de) successivement à partir du substrat :
- une couche d'adhésion (optionnelle), par exemple à base ou essentiellement constituée de silice,
- une couche ou un empilement de neutralisation (notamment une couche haut indice puis une couche bas indice), par exemple une couche essentiellement constituée de nitrure de silicium puis une couche essentiellement constituée de silice,
- une première couche de TCO (notamment ITO),
- une couche intermédiaire, notamment diélectrique, par exemple à base ou essentiellement constituée de silice, de nitrure de silicium ou d'oxyde d'étain et de zinc,
- une deuxième couche de TCO (notamment ITO),
- une couche barrière à l'oxygène, par exemple à base ou essentiellement constituée de nitrure de silicium,
- une couche à bas indice de réfraction, par exemple à base ou essentiellement constituée de silice.

Dans ces combinaisons préférées, les couches successives sont en contact direct avec la couche qui les précède.

Quelques exemples d'empilements particulièrement préférés sont donnés ci-après :
1. Substrat / SiOₓ / ITO / SiNₓ ou SiOₓ ou SnZnOₓ/ ITO / SiNₓ / SiOₓ
2. Substrat / SiNₓ / SiOₓ / ITO / SiNₓ ou SiOₓ ou SnZnOₓ/ ITO / SiNₓ / SiOₓ
3. Substrat / SiOₓ / SiNₓ / SiOₓ / ITO / SiNₓ ou SiOₓ ou SnZnOₓ/ ITO / SiNₓ / SiOₓ
4. Substrat / SiOₓ / ITO / SiNₓ ou SiOₓ ou SnZnOₓ/ ITO / SiNₓ / SiOₓ / TiOₓ
5. Substrat / SiNₓ / SiOₓ / ITO / SiNₓ ou SiOₓ ou SnZnOₓ/ ITO / SiNₓ / SiOₓ / TiOₓ
6. Substrat / SiOₓ / SiNₓ / SiOₓ / ITO / SiNₓ ou SiOₓ ou SnZnOₓ/ ITO / SiNₓ / SiOₓ / TiOₓ.

Dans ces empilements, le substrat est de préférence en verre.

De manière générale, le substrat est de préférence en verre.

Selon un premier mode de réalisation, le substrat en verre est transparent et incolore (il s'agit alors d'un verre clair ou extra-clair). Un verre clair contient typiquement une teneur pondérale en oxyde de fer de l'ordre de 0,05 à 0,2%, tandis qu'un verre extra-clair contient généralement environ 0,005 à 0,03% d'oxyde de fer.

Selon un second mode de réalisation, le verre peut être coloré, par exemple en bleu, vert, gris ou bronze. Le verre contient alors des colorants, principalement de l'oxyde de fer, en des teneurs allant de 0,5 à 2,0% en poids et optionnellement de l'oxyde de cobalt (en des teneurs pondérales allant de 5 à 300 ppm) et/ou du sélénium (en des teneurs pondérales allant de 1 à 10 ppm), voire de l'oxyde de chrome. Ce mode de réalisation est particulièrement bien adapté pour les applications en tant que vitrages automobiles, mais n'est pas préféré dans le cas où l'on cherche à maximiser le facteur solaire.

Le verre est normalement minéral, de préférence de type silico-sodo-calcique, mais il peut également être en verre de type borosilicate ou alumino-borosilicate. L'épaisseur du substrat est généralement comprise dans un domaine allant de 0,5 mm à 19 mm, de préférence de 0,7 à 9 mm, notamment de 2 à 8 mm, voire de 4 à 6 mm. Il en est de même, le cas échéant, pour les autres feuilles de verre du vitrage multiple.

Le substrat de verre est de préférence du type flotté, c'est-à-dire susceptible d'avoir été obtenu par un procédé consistant à déverser le verre fondu sur un bain d'étain en fusion (bain « float »). Dans ce cas, l'empilement peut aussi bien être déposé sur la face « étain » que sur la face « atmosphère » du substrat. On entend par faces « atmosphère » et « étain », les faces du substrat ayant été respectivement en contact avec l'atmosphère régnant dans le bain float et en contact avec l'étain fondu. La face étain contient une faible quantité superficielle d'étain ayant diffusé dans la structure du verre.

Le substrat de verre peut être plan ou bombé, de préférence bombé.

Le substrat de verre peut être trempé thermiquement ou durci pour lui impartir des propriétés de résistance mécanique améliorée et la forme voulue par l'application.

Comme décrit par la suite, la trempe thermique ou le bombage est utile afin d'améliorer les propriétés d'émissivité de la couche de TCO déposée au préalable. De préférence, la résistivité électrique de l'empilement après trempe ou bombage est d'au plus 2,2.10⁻⁴ Ω.cm, notamment d'au plus 2,1.10⁻⁴ Ω.cm et même 2,0.10⁻⁴ Ω.cm. Les propriétés d'émissivité et de résistivité électrique sont étroitement liées.

Le substrat peut aussi être en matière organique polymérique. Les matières organiques polymériques préférées sont le polycarbonate, le polyméthacrylate de méthyle, le polyéthylène téréphtalate (PET), le polyéthylène naphtalate (PEN), ou encore les polymères fluorés tels que l'éthylène tétrafluoroéthylène (ETFE). Ces substrats sont de préférence flexibles, de sorte que leur faible épaisseur permet de les enrouler. L'empilement selon l'invention, de par sa plus grande résistance à la flexion, présente alors l'avantage de ne pas se détériorer lorsque l'empilement est enroulé.

L'invention a également pour objet un vitrage, notamment pour équiper des véhicules terrestres, ferroviaires, maritimes ou aériens, notamment pare-brise, lunettes arrières, vitrages latéraux d'automobile, toits automobile, ou pour équiper des bâtiments, vitrage anti-feu, porte de four ou de réfrigérateur, comprenant au moins un matériau selon l'invention.

Ce vitrage est de préférence bombé. Il présente ainsi une ou plusieurs courbures, avec des rayons de courbure allant typiquement de 10 cm à 40 m. L'invention permet en effet de procurer des matériaux pouvant subir des bombages complexes et de forte intensité, sans présenter de défauts du type fissures ou flou, comme démontré dans la suite du texte.

Le vitrage est par exemple destiné à équiper des véhicules terrestres automobiles. Il peut s'agir en particulier d'un pare-brise, d'une lunette arrière, d'un toit automobile ou d'un vitrage latéral d'automobile.

Ce vitrage peut être feuilleté, notamment dans le cas des pare-brise, des toits ou, parfois, de vitrages latéraux, au sens où le matériau selon l'invention est associé à au moins un autre substrat de verre (typiquement un, mais éventuellement deux ou trois, par exemple dans le cas de vitrages blindés ou pour les véhicules aériens), par au moins une feuille intercalaire en un polymère tel que notamment le polyvinlybutyral (PVB) ou le polyuréthane (PU). Dans ce cas, le matériau selon l'invention est de préférence disposé de manière à ce que l'empilement soit positionné en face 4, c'est-à-dire sur la face extérieure du vitrage destinée à être en contact avec l'habitacle du véhicule. Au moins une face située à l'intérieur du feuilleté (face 2 ou 3), ou une face d'une feuille intercalaire, est de préférence revêtue d'un empilement à propriétés de faible émissivité, par exemple d'au plus 0,1 ou 0,05. Il peut s'agir notamment d'empilements de couches minces comprenant au moins une couche d'argent, la ou chaque couche d'argent étant disposée entre des couches diélectriques.

Dans le cas des lunettes arrière ou des vitrages latéraux, le vitrage est normalement non-feuilleté, mais trempé. En position d'utilisation, l'empilement sera préférentiellement disposé en face 2, c'est-à-dire sur la face extérieure du vitrage destinée à être en contact avec l'habitacle du véhicule.

Dans ce type d'applications, le substrat est avantageusement teinté, notamment en vert, en bleu ou en gris. A cet effet, le substrat de verre peut contenir un ou plusieurs colorants, tels que notamment l'oxyde de fer, en une teneur pondérale allant de 0,5 à 2,5%, l'oxyde de cobalt, en une teneur pondérale allant de 0,0010 à 0,03%, l'oxyde de chrome, en une teneur pondérale allant de 0,005 à 0,05%, le sélénium, en une teneur pondérale allant de 0,0001 à 0,005%. Dans des applications du type lunette arrière, toit ou latérales arrière, la transmission lumineuse du vitrage peut par exemple être comprise entre 5 et 70% (5 à 20% pour un toit). Dans des applications du type pare-brise ou latérales avant, la transmission lumineuse du vitrage sera de préférence d'au moins 70%, voire 75%.

Le vitrage peut aussi être destiné à équiper des bâtiments. Il s'agira de préférence d'un vitrage multiple, notamment double ou triple, voire plus, par exemple quadruple. Un vitrage double est généralement constitué de deux feuilles de verre se faisant face et ménageant une lame de gaz, par exemple d'air, d'argon, de xénon ou encore de krypton. On dispose généralement à la périphérie du vitrage, entre les feuilles de verre, un cadre espaceur, sous la forme d'un profilé métallique, par exemple en aluminium, solidarisé aux feuilles de verre par une colle, la périphérie du vitrage étant scellée à l'aide d'un mastic, par exemple en silicone, polysulfures ou polyuréthane, pour éviter toute entrée d'humidité au sein de la lame de gaz. Pour limiter l'humidité, on dispose fréquemment un tamis moléculaire dans le cadre espaceur. Un triple vitrage est constitué de la même manière, si ce n'est que le nombre de feuilles de verre est de trois.

Le vitrage multiple peut comprendre un ou plusieurs matériaux selon l'invention, notamment un matériau selon l'invention disposé de sorte que son empilement soit disposé en face 1 du vitrage et/ou un matériau selon l'invention disposé de sorte que son empilement soit disposé en face 4 du vitrage (pour un vitrage double) ou en face 6 (pour un vitrage triple). La disposition en face 1, c'est-à-dire en contact avec l'extérieur du bâtiment, permet de conférer des propriétés d'anti-condensation au vitrage, tandis que la disposition en face 4 ou 6 (en contact avec l'intérieur de l'habitation) procure des fonctions d'isolation thermique renforcée.

Lorsque le vitrage selon l'invention est un vitrage triple, au moins une autre face, choisie parmi les faces 2 à 5, est de préférence revêtue d'un empilement à propriétés de faible émissivité. Il peut s'agir notamment d'empilements de couches minces comprenant au moins une couche d'argent, la ou chaque couche d'argent étant disposée entre des couches diélectriques. On entend par faible émissivité une émissivité généralement d'au plus 0,1, notamment 0,05. De préférence, deux autres faces, notamment les faces 2 et 5 sont revêtues d'un tel empilement. D'autres configurations sont également possibles, mais moins préférées : faces 2 et 3, 2 et 4, 3 et 4, 4 et 5, faces 2, 3 et 4, faces 2, 3 et 5, faces 2, 4 et 5, faces 2, 3, 4 et 5. Lorsque le vitrage selon l'invention est un vitrage double, la face 2 est avantageusement revêtue d'un empilement à propriétés de faible émissivité, notamment du type de celui qui vient d'être décrit. Alternativement, la face 2 peut être revêtue d'un empilement de contrôle solaire, ce qui n'est toutefois pas préféré car un tel empilement conduit à réduire le facteur solaire.

Pour améliorer les propriétés acoustiques ou de résistance à l'effraction du vitrage selon l'invention, au moins une feuille de verre du vitrage peut être feuilletée à une autre feuille au moyen d'une feuille intercalaire en un polymère tel que le polyvinlybutyral (PVB) ou le polyuréthane (PU).

Le vitrage selon l'invention peut être employé comme tout type de vitrage. Il peut être intégré à une façade, une toiture, une véranda. Il peut être disposé à la verticale ou incliné.

Pour une utilisation dans un vitrage anti-feu ou une porte de four, le substrat est avantageusement en un verre résistant à la chaleur, par exemple un borosilicate ou un aluminosilicate.

L'invention aussi pour objet un procédé d'obtention d'un matériau selon l'invention, dans lequel les couches sont déposées, notamment par pulvérisation cathodique, puis subissent un traitement thermique choisi parmi les traitements de trempe, de bombage, de recuit, de recuit rapide.

De préférence, le recuit rapide est mis en œuvre à l'aide d'une flamme, d'une torche plasma ou d'un rayonnement laser.

Les couches de l'empilement sont de préférence déposées sur un substrat de verre plan, qui se présente alors généralement sous la forme d'une grande feuille de verre de 3,2*6m², ou directement sur le ruban de verre pendant ou juste après le processus de flottage, puis le substrat est découpé aux dimensions voulues.

Les différentes couches de l'empilement peuvent être déposées sur le substrat en verre par tout type de procédé de dépôt de couche mince. Il peut par exemple s'agir de procédés de type sol-gel, pyrolyse (liquide ou solide), dépôt chimique en phase vapeur (CVD), notamment assisté par plasma (APCVD), éventuellement sous pression atmosphérique (APPECVD), évaporation.

Les couches de l'empilement sont de préférence déposées par pulvérisation cathodique, notamment assistée par un champ magnétique (procédé magnétron). C'est de préférence le cas lorsque la couche de TCO est une couche d'ITO. Dans ce procédé, un plasma est créé sous un vide poussé au voisinage d'une cible comprenant les éléments chimiques à déposer. Les espèces actives du plasma, en bombardant la cible, arrachent lesdits éléments, qui se déposent sur le substrat en formant la couche mince désirée. Ce procédé est dit « réactif » lorsque la couche est constituée d'un matériau résultant d'une réaction chimique entre les éléments arrachés de la cible et le gaz contenu dans le plasma. L'avantage majeur de ce procédé réside dans la possibilité de déposer sur une même ligne un empilement très complexe de couches en faisant successivement défiler le substrat sous différentes cibles, ce généralement dans un seul et même dispositif.

Le procédé magnétron présente toutefois un inconvénient lorsque le substrat n'est pas chauffé lors du dépôt : les couches de TCO obtenues sont faiblement cristallisées si bien que leurs propriétés d'émissivité ne sont pas optimisées. Un traitement thermique se révèle alors nécessaire. De préférence, le traitement thermique met en œuvre des températures supérieures à 200°C, notamment 400°C et même 600°C ou 700°C au niveau de l'empilement et/ou du substrat.

Le traitement thermique peut être destiné à améliorer la cristallisation des couches de TCO et donc l'émissivité de l'empilement (cas de la trempe, du bombage, du recuit, du recuit rapide), et/ou à conférer des propriétés mécaniques améliorées (cas de la trempe) et/ou à donner une forme voulue (cas du bombage).

L'amélioration de la cristallisation peut être quantifiée par une augmentation du taux de cristallisation (la proportion massique ou volumique de matière cristallisée) et/ou de la taille des grains cristallins (ou la taille de domaines cohérents de diffraction mesurés par des méthodes de diffraction des rayons X ou de spectroscopie Raman). Cette amélioration de la cristallisation peut aussi être vérifiée de manière indirecte, par l'amélioration des propriétés de la couche. Dans le cas d'une couche de type TCO, l'émissivité diminue, de préférence d'au moins 5% en relatif, voire d'au moins 10% ou 15%, de même que son absorption lumineuse et énergétique.

Le traitement de trempe ou de recuit est généralement mis en œuvre dans un four, respectivement de trempe ou de recuisson. L'intégralité du substrat (revêtu de l'empilement), est portée à une température élevée, d'au moins 300°C dans le cas de la recuisson, et d'au moins 500°C, voire 600°C, dans le cas d'une trempe. Dans ce dernier cas, le substrat est ensuite brutalement refroidi afin de créer en surface du verre des contraintes de compression qui vont le renforcer mécaniquement. Selon le niveau des contraintes obtenues, on peut parfois employer les termes de durcissement, de semi-trempe, ou de trempe proprement dite, tous ces traitements étant compris dans l'expression « trempe » au sens de l'invention.

Le bombage est généralement mis en œuvre dans un four de bombage. L'intégralité du substrat (revêtu de l'empilement), est portée à une température élevée, d'au moins 500°C, notamment comprise entre 500 et 700°C. Le bombage permet de créer une ou plusieurs courbures, avec des rayons de courbure allant typiquement de 10 cm à 40 m. Le bombage peut être suivi d'un refroidissement rapide afin de créer en surface du verre des contraintes de compression qui vont le renforcer mécaniquement ; on parle dans ce cas d'un bombage-trempe.

Après trempe ou bombage-trempe, les contraintes de surface sont avantageusement d'au moins 60 MPa, voire 70 MPa.

Le recuit rapide est de préférence mis en œuvre à l'aide d'une flamme, d'une torche plasma ou d'un rayonnement laser. Dans ce type de procédé, on vient créer un mouvement relatif entre le substrat et le dispositif (flamme, laser, torche plasma). Généralement, le dispositif est mobile, et le substrat revêtu vient défiler au regard du dispositif de manière à traiter sa surface. Ces procédés permettent d'apporter une grande densité d'énergie au revêtement à traiter en un temps très faible, limitant ainsi la diffusion de la chaleur vers le substrat, et donc le chauffage dudit substrat. La température du substrat est généralement d'au plus 100°C, voire 50° et même 30°C pendant le traitement. Chaque point de la couche mince est soumis au traitement de recuit rapide pendant une durée généralement inférieure ou égale à 1 seconde, voire 0,5 seconde.

Le traitement thermique de recuit rapide est de préférence mis en œuvre à l'aide d'un rayonnement laser émettant dans l'infrarouge ou le visible. La longueur d'onde du rayonnement est de préférence comprise dans un domaine allant de 530 à 1200 nm, ou de 600 à 1000 nm, notamment de 700 à 1000 nm, voire de 800 à 1000 nm. On utilise de préférence des diodes laser, émettant par exemple à une longueur d'onde de l'ordre de 808 nm, 880 nm, 915 ou encore 940 nm ou 980 nm. Sous forme de systèmes de diodes, de très fortes puissances peuvent être obtenues, permettant d'atteindre des puissances surfaciques au niveau du revêtement à traiter supérieures à 20kW/cm², voire à 30kW/cm².

Le rayonnement laser est de préférence issu d'au moins un faisceau laser formant une ligne (appelée « ligne laser » dans la suite du texte) qui irradie simultanément toute ou partie de la largeur du substrat. Ce mode est préféré car il évite l'utilisation de systèmes de déplacement coûteux, généralement encombrants, et d'entretien délicat. Le faisceau laser en ligne peut notamment être obtenu à l'aide de systèmes de diodes laser de forte puissance associées à une optique de focalisation. L'épaisseur de la ligne est de préférence comprise entre 0,01 et 1 mm. La longueur de la ligne est typiquement comprise entre 5 mm et 3,2 m. Le profil de la ligne peut notamment être une courbe de Gauss ou un créneau. La ligne laser irradiant simultanément toute ou partie de la largeur du substrat peut être composée d'une seule ligne (irradiant alors toute la largeur du substrat), ou de plusieurs lignes, éventuellement disjointes. Lorsque plusieurs lignes sont utilisées, il est préférable qu'elles soient disposées de sorte que toute la surface de l'empilement soit traitée. La ou chaque ligne est de préférence disposée perpendiculairement à la direction de défilement du substrat, ou disposée de manière oblique. Les différentes lignes peuvent traiter le substrat simultanément, ou de manière décalée dans le temps. L'important est que toute la surface à traiter le soit. Le substrat peut ainsi être mis en déplacement, notamment en défilement en translation en regard de la ligne laser fixe, généralement en dessous, mais éventuellement au-dessus de la ligne laser. Ce mode de réalisation est particulièrement appréciable pour un traitement en continu. Alternativement, le substrat peut être fixe et le laser peut être mobile. De préférence, la différence entre les vitesses respectives du substrat et du laser est supérieure ou égale à 1 mètre par minute, voire 4 et même 6, 8, 10 ou 15 mètres par minute, ce afin d'assurer une grande vitesse de traitement. Lorsque le substrat est en déplacement, notamment en translation, il peut être mis en mouvement à l'aide de tous moyens mécaniques de convoyage, par exemple à l'aide de bandes, de rouleaux, de plateaux en translation. Le système de convoyage permet de contrôler et réguler la vitesse du déplacement. Le laser peut également être mis en mouvement de manière à ajuster sa distance au substrat, ce qui peut être utile en particulier lorsque le substrat est bombé, mais pas seulement. En effet, il est préférable que le faisceau laser soit focalisé sur le revêtement à traiter de sorte que ce dernier soit situé à une distance inférieure ou égale à 1 mm du plan focal. Si le système de déplacement du substrat ou du laser n'est pas suffisamment précis quant à la distance entre le substrat et le plan focal, il convient de préférence de pouvoir ajuster la distance entre le laser et le substrat. Cet ajustement peut être automatique, notamment régulé grâce à une mesure de la distance en amont du traitement.

Le dispositif de rayonnement laser peut être intégré dans une ligne de dépôt de couches, par exemple une ligne de dépôt par pulvérisation cathodique assistée par champ magnétique (procédé magnétron), ou une ligne de dépôt chimique en phase vapeur (CVD), notamment assistée par plasma (PECVD), sous vide ou sous pression atmosphérique (APPECVD).

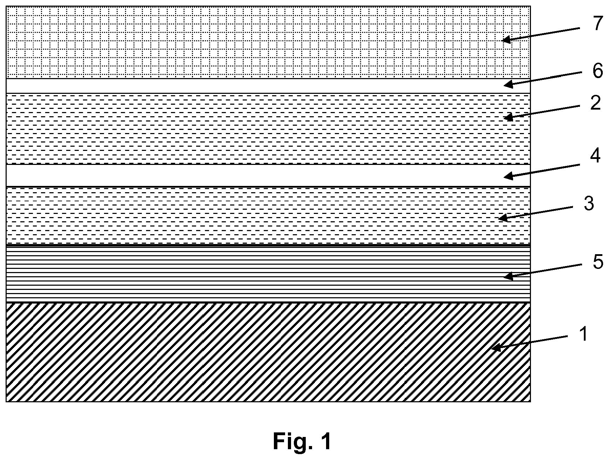

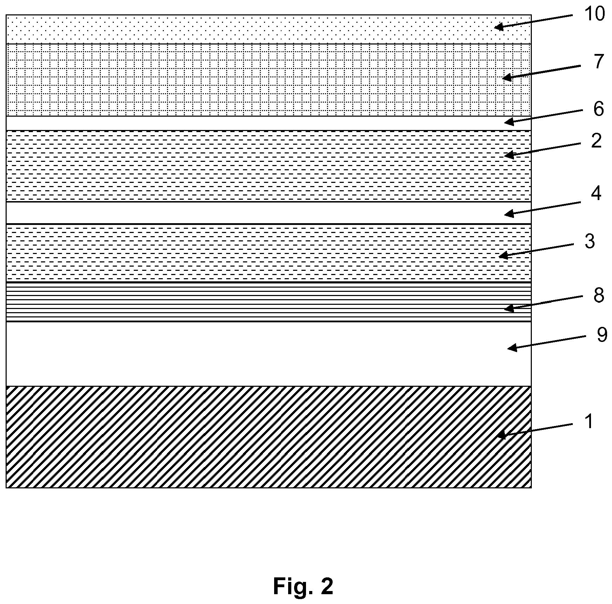

Les Figures 1 et 2 illustrent de manière schématique une coupe d'une partie des modes de réalisation préférés de l'invention. Seul l'empilement disposé sur le substrat et une partie du substrat (notamment de verre) sont représentés.

Sont représentées, déposées sur le substrat 1, les couches 2 et 3 d'un oxyde transparent électro-conducteur (typiquement l'ITO), la couche intermédiaire 4 (par exemple en silice ou en nitrure de silicium ou encore en oxyde de zinc et d'étain) et la couche barrière à l'oxygène 6 (typiquement en nitrure de silicium).

Les autres couches (optionnelles) représentées en Figure 1 sont une couche d'adhésion 5 (par exemple en silice) et une couche à bas indice de réfraction 7 (par exemple en silice).

En Figure 2 les couches (optionnelles) représentées sont :
- sur la couche barrière à l'oxygène 6 (typiquement en nitrure de silicium), une couche à bas indice de réfraction 7 (par exemple en silice), et une couche de protection 10 (typiquement en TiO₂, qui peut être photocatalytique),
- sous la couche de TCO 3 une couche à bas indice de réfraction 8 (typiquement en silice) et une couche à haut indice de réfraction 9 (typiquement en nitrure de silicium).

Les exemples qui suivent illustrent l'invention sans toutefois la limiter.

On a déposé de manière connue sur des substrats de verre, par pulvérisation cathodique magnétron, des empilements tels que décrits dans le tableau 1 ci-après, du type de celui de la Figure 1.

Le tableau indique les épaisseurs physiques (en nm) de chacune des couches de l'empilement. La première ligne du tableau correspond à la dernière couche de l'empilement (en contact avec l'atmosphère). En deuxième colonne du tableau est indiquée la référence de la couche correspondante utilisée en Figure 1. Les couches de nitrure et d'oxyde de silicium sont dopées à l'aluminium pour faciliter leur dépôt par pulvérisation cathodique magnétron.

**Tableau 1**

| | | C1 | C2 | 1 | 2 | 3 | 4 |
|---|---|---|---|---|---|---|---|
| SiOₓ | 7 | 70 | 70 | 70 | 70 | 70 | 70 |
| SiNₓ | 6 | 20 | 20 | 20 | 20 | 20 | 20 |
| ITO | 2 | - | - | 60 | 50 | 60 | 40 |
| SiOₓ | 4 | - | - | - | 10 | 10 | - |
| SiNₓ | 4 | - | - | 10 | - | - | 10 |
| ITO | 3 | 120 | 100 | 60 | 50 | 60 | 40 |
| SiOₓ | 5 | 35 | 35 | 35 | 35 | 35 | 35 |

Les exemples C1 et C2 sont des exemples comparatifs, ne comprenant qu'une seule couche de TCO, déposée sur une couche d'adhésion et revêtue d'une couche barrière à l'oxygène et d'une couche à bas indice.

Les exemples selon l'invention 1 à 4 comprennent en revanche deux couches de TCO (ici de l'ITO) séparées par une couche intermédiaire diélectrique en oxyde ou en nitrure de silicium selon les cas.

Ces empilements ont été déposés sur deux types de substrats de verre flotté : un substrat de verre clair (contenant 0,1% d'oxyde de fer), dont le facteur de transmission lumineuse est supérieur à 85%, et un substrat de verre gris foncé, dont le facteur de transmission lumineuse est inférieur à 30%.

Les substrats revêtus ont ensuite subi une étape de bombage-trempe. Le bombage était de type gravitationnel sur un cadre de bombage rectangulaire conférant une forme cylindrique, avec un rayon de courbure de 20 cm.

Le bombage est dit « convexe » lorsque l'empilement est situé du côté convexe après bombage, ou « concave » lorsque l'empilement est situé du côté concave après bombage. Dans le cas d'un bombage convexe, l'empilement subit des contraintes en tension qui peuvent générer des fissures et/ou du flou. Dans le cas d'un bombage concave, l'empilement subit des contraintes en compression pouvant générer du flou.

Les tableaux 2 et 3 ci-après récapitulent les résultats obtenus.

Pour chaque essai, les tableaux indiquent :
- la nature du verre (« T » pour le verre teinté en gris foncé, « C » pour le verre clair),
- le type d'empilement, désigné par les références utilisées dans le tableau 1,
- la résistance carrée mesurée avant et après bombage-trempe,
- le type de bombage : convexe (CV) ou concave (CC),
- une note de 0 à 10 permettant d'apprécier de manière qualitative la quantité de fissures après bombage, suite à un examen visuel, une note de 0 témoignant de l'absence de fissures,
- une note de 0 à 10 permettant d'apprécier de manière qualitative le flou après bombage, suite à un examen visuel, une note de 0 témoignant de l'absence de flou,

**Tableau 2**

| Verre | T | T | T | C | T | T |
|---|---|---|---|---|---|---|
| Empilement | C1 | C2 | | 1 | | 2 |
| R_{c} avant (Ω) | 53 | 63 | | 55 | | 67 |
| R_{c} après (Ω) | 19 | 24 | | 20 | | 24 |
| Bombage | CV | CC | CV | CC | CV | CC |
| Fissures | 5 | - | 0 | - | 0 | - |
| Flou | 0 | 8 | 8 | 2 | 0 | 0 |

**Tableau 3**

| Verre | C | T | T | C | C |
|---|---|---|---|---|---|
| Empilement | 2 | 3 | | 4 | |
| R_{c} avant (Ω) | 68 | 54 | | 83 | |
| R_{c} après (Ω) | | 19 | | 31 | |
| Bombage | CV | CC | CV | CV | CC |
| Fissures | 0 | - | 0 | 0 | - |
| Flou | 0 | 0 | 0 | 0 | 0 |

Ces résultats montrent que remplacer une couche de TCO unique par deux couches du même TCO, d'épaisseur cumulée égale à l'épaisseur de la couche unique, permet d'atteindre le même niveau de résistance carrée, et donc les mêmes performances bas-émissives : environ 19 Ω pour une épaisseur totale de 120 nm et 24 Ω pour une épaisseur totale de 100 nm.

Dans le même temps, la résistance au bombage et à la trempe est nettement améliorée grâce à l'invention. Les empilements selon l'invention permettent donc de résister à des traitements de bombage plus intenses (plus faibles rayons de courbure) que les empilements non conformes à l'invention.

## Revendications

1. Matériau comprenant un substrat (1) revêtu sur au moins une partie d'au moins une de ses faces d'un empilement de couches minces comprenant au moins deux couches à base d'un oxyde transparent électro-conducteur (2,3) séparées par au moins une couche intermédiaire diélectrique (4) dont l'épaisseur physique est d'au plus 50 nm, aucune couche métallique n'étant disposée entre lesdites couches à base d'un oxyde transparent électro-conducteur (2,3), ledit empilement comprenant en outre au moins une couche barrière à l'oxygène (6) au-dessus de la couche à base d'un oxyde transparent électro-conducteur (2) la plus éloignée du substrat (1), chaque couche à base d'un oxyde transparent électro-conducteur (2,3) possédant une épaisseur physique comprise dans un domaine allant de 20 à 80 nm.

2. Matériau selon la revendication précédente, tel que le substrat (1) est en verre.

3. Matériau selon l'une des revendications précédentes, tel que chaque oxyde transparent électro-conducteur (2,3) est choisi parmi l'oxyde mixte d'étain et d'indium, l'oxyde mixte d'indium et de zinc, l'oxyde de zinc dopé au gallium ou à l'aluminium, l'oxyde de titane dopé au niobium, le stannate de cadmium ou de zinc, l'oxyde d'étain dopé au fluor et/ou à l'antimoine.

4. Matériau selon l'une des revendications précédentes, tel que chaque couche à base d'un oxyde transparent électro-conducteur (2,3) possède une épaisseur physique comprise dans un domaine allant de 30 à 80 nm.

5. Matériau selon l'une des revendications précédentes, tel que l'épaisseur physique cumulée de toutes les couches à base d'un oxyde transparent électro-conducteur (2,3) est comprise dans un domaine allant de 40 à 400 nm, notamment de 60 à 300 nm.

6. Matériau selon l'une des revendications précédentes, tel que l'empilement de couches minces comprend deux couches à base d'un oxyde transparent électro-conducteur (2,3) séparées par au plus deux couches intermédiaires diélectriques (4), notamment par une seule couche intermédiaire diélectrique (4).

7. Matériau selon l'une des revendications précédentes, tel que la ou chaque couche intermédiaire diélectrique (4) est à base d'un composé choisi parmi les oxydes, les nitrures ou les oxynitrures de silicium, d'aluminium, de titane, d'étain, de zinc, de zirconium, de niobium, de nickel, de chrome ou d'un de leurs mélanges.

8. Matériau selon l'une des revendications précédentes, tel que l'épaisseur physique de la ou chaque couche intermédiaire diélectrique (4) est comprise dans un domaine allant de 2 à 20 nm, notamment de 5 à 15 nm.

9. Matériau selon l'une des revendications précédentes, tel que la couche barrière (6) est à base d'un composé choisi parmi le nitrure de silicium, l'oxyde de niobium, l'oxyde de tungstène, l'oxyde de bismuth, l'oxyde de titane, le nitrure de zirconium et le nitrure d'aluminium.

10. Matériau selon l'une des revendications précédentes, tel que l'empilement comprend, sous la couche à base d'un oxyde transparent électro-conducteur (3) la plus proche du substrat, au moins une couche d'adhésion (5), notamment en silice.

11. Procédé d'obtention d'un matériau selon l'une des revendications précédentes, dans lequel les couches sont déposées, notamment par pulvérisation cathodique, puis subissent un traitement thermique choisi parmi les traitements de trempe, de bombage, de recuit, de recuit rapide.

12. Procédé selon la revendication précédente, tel que le recuit rapide est mis en œuvre à l'aide d'une flamme, d'une torche plasma ou d'un rayonnement laser.

13. Vitrage, notamment pour équiper des véhicules terrestres, ferroviaires, maritimes ou aériens, notamment pare-brise, lunettes arrières, vitrages latéraux d'automobile, toits automobile, ou pour équiper des bâtiments, vitrage anti-feu, porte de four ou de réfrigérateur, comprenant au moins un matériau selon l'une des revendications de matériau précédentes.

14. Vitrage selon la revendication précédente, qui est un vitrage bombé.

## Patentansprüche

1. Material, umfassend ein Substrat (1), das auf mindestens einem Teil mindestens einer seiner Flächen mit einer Stapelung von Dünnschichten beschichtet ist, die mindestens zwei Schichten auf Basis eines elektrisch leitfähigen transparenten Oxids (2,3) umfasst, die durch mindestens eine dielektrische Zwischenschicht (4) getrennt sind, deren physische Dicke höchstens 50 nm beträgt, wobei zwischen den Schichten auf Basis eines elektrisch leitfähigen transparenten Oxids (2,3) keine Metallschicht angeordnet ist, wobei die Stapelung ferner mindestens eine Sauerstoffbarriereschicht (6) über der am weitesten vom Substrat (1) entfernten Schicht auf Basis eines elektrisch leitfähigen transparenten Oxids (2) umfasst, wobei jede Schicht auf Basis eines elektrisch leitfähigen transparenten Oxids (2,3) eine physische Dicke in einem Bereich, der von 20 bis 80 nm reicht, aufweist.

2. Material nach dem vorstehenden Anspruch, wobei das Substrat (1) aus Glas besteht.

3. Material nach einem der vorstehenden Ansprüche, wobei jedes elektrisch leitfähige transparente Oxid (2,3) ausgewählt ist aus gemischtem Oxid von Zinn und Indium, gemischtem Oxid von Indium und Zink, mit Gallium oder Aluminium dotiertem Zinkoxid, mit Niob dotiertem Titanoxid, Cadmium- oder Zinkstannat, mit Fluor und/oder Antimon dotiertem Zinnoxid.

4. Material nach einem der vorstehenden Ansprüche, wobei jede Schicht auf Basis eines elektrisch leitfähigen transparenten Oxids (2,3) eine physische Dicke in einem Bereich, der von 30 bis 80 nm reicht, aufweist.

5. Material nach einem der vorstehenden Ansprüche, wobei die kumulative physische Dicke aller Schichten auf Basis eines elektrisch leitfähigen transparenten Oxids (2,3) in einem Bereich, der von 40 bis 400 nm, insbesondere von 60 bis 300 nm, reicht, liegt.

6. Material nach einem der vorstehenden Ansprüche, wobei die Stapelung von Dünnschichten zwei Schichten auf Basis eines elektrisch leitfähigen transparenten Oxids (2,3) umfasst, die durch höchstens zwei dielektrische Zwischenschichten (4), insbesondere durch eine einzige dielektrische Zwischenschicht (4), getrennt sind.

7. Material nach einem der vorstehenden Ansprüche, wobei die oder jede dielektrische Zwischenschicht (4) auf einer Verbindung basiert, die ausgewählt ist aus Oxiden, Nitriden oder Oxynitriden von Silicium, von Aluminium, von Titan, von Zinn, von Zink, von Zirkonium, von Niob, von Nickel, von Chrom oder einer deren Mischungen.

8. Material nach einem der vorstehenden Ansprüche, wobei die physische Dicke der oder jeder dielektrischen Zwischenschicht (4) in einem Bereich, der von 2 bis 20 nm, insbesondere von 5 bis 15 nm, reicht, liegt.

9. Material nach einem der vorstehenden Ansprüche, wobei die Sperrschicht (6) auf einer Verbindung basiert, die ausgewählt ist aus Siliciumnitrid, Nioboxid, Wolframoxid, Bismutoxid, Titanoxid, Zirkoniumnitrid und Aluminiumnitrid.

10. Material nach einem der vorstehenden Ansprüche, wobei die Stapelung unter der dem Substrat am nächsten liegenden Schicht auf Basis eines elektrisch leitfähigen transparenten Oxids (3) mindestens eine Haftschicht (5), insbesondere aus Siliciumdioxid, umfasst.

11. Verfahren zur Herstellung eines Materials nach einem der vorstehenden Ansprüche, bei dem die Schichten abgeschieden werden, insbesondere durch Kathodenzerstäubung, anschließend einer Wärmebehandlung, ausgewählt aus den Behandlungen Härten, Biegen, Glühen, Schnellglühen, unterzogen werden.

12. Verfahren nach dem vorstehenden Anspruch, wobei das Schnellglühen mithilfe einer Flamme, eines Plasmabrenners oder einer Laserstrahlung durchgeführt wird.

13. Verglasung, insbesondere zum Ausstatten von Land-, Schienen-, See- oder Luftfahrzeugen, insbesondere Windschutzscheibe, Heckscheiben, Automobilseitenscheiben, Automobildächer, oder zum Ausstatten von Gebäuden, Brandschutzverglasung, Ofen- oder Kühlschranktür, umfassend mindestens ein Material nach einem der vorstehenden Materialansprüche.

14. Verglasung nach dem vorstehenden Anspruch, die eine gebogene Verglasung ist.

## Claims

1. A material comprising a substrate (1) coated on at least some of at least one of its faces with a thin-film multilayer comprising at least two films based on a transparent electrically conductive oxide (2, 3), said films being separated by at least one dielectric intermediate film (4) the physical thickness of which is at most 50 nm, no metal films being deposited between said films based on a transparent electrically conductive oxide (2, 3), said multilayer furthermore comprising at least one oxygen barrier film (6) above that film based on a transparent electrically conductive oxide (2) which is furthest from the substrate (1), each film based on a transparent electrically conductive oxide (2, 3) possessing a physical thickness comprised in a range extending from 20 to 80 nm.

2. The material as claimed in the preceding claim, such that the substrate (1) is made of glass.

3. The material as claimed in one of the preceding claims, such that each transparent electrically conductive oxide (2, 3) is chosen from mixed indium tin oxide, mixed indium zinc oxide, gallium- or aluminum-doped zinc oxide, niobium-doped titanium oxide, zinc or cadmium stannate and antimony- and/or fluorine-doped tin oxide.

4. The material as claimed in one of the preceding claims, such that each film based on a transparent electrically conductive oxide (2, 3) possesses a physical thickness comprised in a range extending from 30 to 80 nm.

5. The material as claimed in one of the preceding claims, such that the cumulative physical thickness of all the films based on a transparent electrically conductive oxide (2, 3) is comprised in a range extending from 40 to 400 nm and especially from 60 to 300 nm.

6. The material as claimed in one of the preceding claims, such that the thin-film multilayer comprises two films based on a transparent electrically conductive oxide (2, 3), said films being separated by at most two dielectric intermediate films (4) and especially by a single dielectric intermediate film (4).

7. The material as claimed in one of the preceding claims, such that the or each dielectric intermediate film (4) is based on a compound chosen from oxides, nitrides or oxynitrides of silicon, aluminum, titanium, tin, zinc, zirconium, niobium, nickel, chromium or one of their mixtures.

8. The material as claimed in one of the preceding claims, such that the physical thickness of the or each dielectric intermediate film (4) is comprised in a range extending from 2 to 20 nm and especially from 5 to 15 nm.

9. The material as claimed in one of the preceding claims, such that the barrier film (6) is based on a compound chosen from silicon nitride, niobium oxide, tungsten oxide, bismuth oxide, titanium oxide, zirconium nitride and aluminum nitride.

10. The material as claimed in one of the preceding claims, such that the multilayer comprises, under the film based on a transparent electrically conductive oxide (3) closest to the substrate, at least one adhesion film (5), especially made of silica.

11. A process for obtaining a material as claimed in one of the preceding claims, in which the films are deposited, especially by cathode sputtering, then undergo a heat treatment chosen from tempering, bending, annealing and rapid annealing treatments.

12. The process as claimed in the preceding claim, such that the rapid annealing is carried out using a flame, a plasma torch or laser radiation.

13. A glazing unit, especially for equipping ground, rail, water or aerial vehicles, especially an automobile windshield, rear windshield or side window or an automobile roof, or for equipping buildings, or a fire-resistant glazing unit, or an oven or refrigerator door, comprising at least one material according to one of the preceding material claims.

14. The glazing unit as claimed in the preceding claim, which is a curved glazing unit.
